# EUROPEAN PATENT SPECIFICATION

(11) **EP 0 646 290 B1**
(45) Date of publication and mention of the grant of the patent: **12.04.2000**
(21) Application number: 93915375.5
(22) Date of filing: 15.06.1993
(51) Int. Cl.: H01R 12/18

(54) **FACE-MOUNT CONNECTOR**
OBERFLÄCHENMONTIERBARER VERBINDER
CONNECTEUR A MONTAGE PAR LES FACES

(30) Priority: 15.06.1992 JP 15538992
(43) Date of publication of application: 05.04.1995
(73) Proprietor: BERG ELECTRONICS MANUFACTURING B.V., 5222 AV's-Hertogenbosch (NL)
(72) Inventor: LWEE, Nai, Hock, Singapore 0512 (SG)
(74) Representative: Barnard, Eric Edward
(86) International application number: US9305745
(87) International publication number: WO9326063

(56) References cited:
- US-A- 4 316 235
- US-A- 5 106 313

## Description

The present invention relates generally to an electric connector and, in particular, to a method of mounting an electric connector on a circuit board and to means for co-operating with the electric connector in performing the method. For example, a PCMCIA receptacle for connecting a memory card to a printed circuit board belongs to the technical field of the present invention.

A through hole mount method and a face mount method using no through holes are known as a method for connecting an electric connector to a printed circuit board.

The through hole mount method comprises inserting pin contacts of an electric connector into through holes of a printed circuit board to achieve their soldering. The drawbacks of this method lie in that, because of the need to pierce through holes into a printed circuit board, the method is not suitable for an electric connector with pin contacts arranged at a very small pitch from the viewpoint of a through hole formation limitation and that, because the presence of through holes, a wiring pattern to be formed on the printed circuit board is subject to a design limitation.

As an electric connector for connecting a memory card to a printed circuit board, the PCMCIA (Personal Computer Memory Card International Association) receptacles are commercially available on the market.

In the case where the PCMCIA receptacle is mounted on the printed circuit board, the face mount method is employed because pin contacts are arranged at a very small pitch. In the face mount method, the receptacle is placed on the printed circuit board and those solder tails of the receptacle are soldered to corresponding solder pads on the printed circuit board by an infrared radiation or a vapor-phase reflow soldering processing. According to the face mount method for the PCMCIA receptacles, it is possible to eliminate the aforementioned two drawbacks.

Unless, however, the receptacle or electric connector is properly seated on the printed circuit board and solder tails are properly seated on the corresponding solder pads during a soldering time, the receptacle is floated from the printed circuit board, or tilted relative to the surface of the printed circuit board, after the soldering step has been carried out.

### Summary of the Invention

An object of the present invention is to provide a method of mounting an electric connector on a circuit board, which ensures better horizontal alignment of the electric connector after a soldering step has been done.

Another object of the present invention is to provide means to perform the mounting method and usable with an electric connector to ensure its better horizontal alignment.

In one aspect of the present invention there is provided a method of mounting an electric connector on a circuit board with solder pads formed on a surface thereof, the electric connector comprising an elongated housing having opposite first and second elongated surfaces and a third elongated surface extending between the first and second elongated surfaces in a perpendicular relationship therewith and a plurality of conductive pins extending through the first and second elongated surfaces with solder tails extending from the first surface of the housing for placement on the solder pads, the method comprising the steps of:
providing a support plate breakably connected with the circuit board, the support plate including one edge for confronting the second surface of the housing and having a surface aligned on substantially the same plane as the surface of the circuit board;
providing a support member for locating with the surface of the support plate and the second surface of the housing;
placing the housing at a substantially horizontal attitude relative to the surface of the circuit board so that the solder tails of the electric connector are seated on the corresponding solder pads on the electric board;
supporting the housing at the horizontal attitude by means of the support member located on the support plate adjacent the one edge so as to hold the housing at the horizontal attitude to ensure the positional relationship between the solder tail and the corresponding solder pads and
soldering the solder tails of the electric connector to the corresponding solder pads on the circuit board.

To perform the method the present invention also provides a mounting kit comprising the combination of a circuit board with solder pads on a surface thereof, a support plate breakably connected to the circuit board and defining an edge for confronting an elongate surface of a housing of an electrical connector having conductive pins extending between the elongate surface and a second elongate surface from which the pins extend as solder tails for soldering onto the solder pads and at least one support member which is adapted to locate and support the housing in relation to a surface of the support plate aligned with the surface of the circuit board.

As will appear hereinafter, one or several support members can be used. The or each support member can take the form of a support pad of T-shaped configuration with a mating or support section for engaging with the elongate surface of the housing adjacent the one edge of the support plate and a gripping or seating section for engaging on the surface of the support plate aligned with the surface of the circuit board equipped with the solder pads. The support plate may be joined to the circuit board with breakable projections. The support plate may thus have an opening defining the one edge as well as further edges extending from this one edge up to the projections. The housing of the connector may have pegs on its end surfaces which abut on the projections when the housing is being placed and supported.

The or each support member or pad may have grooves on the mating or support section which slidable fit onto ribs on the longitudinal edges of the associated surface of the housing. The mating or support section may also possess an array of pins which fit into header socket portions of the conductive pins of the connector opposite the solder tails.

In another embodiment the or each support member has a pin which fits into a hole in the support plate adjacent the one edge confronting the housing of the connector.

According to the present invention, prior to the soldering process, the housing of the electric connector is supported by the circuit board at its solder tail-side surface and by the support plate at its header-side surface. Since the surface of the support plate and surface of the circuit board are located on substantially the same plane, the housing of the electric connector is held in a horizontal position to the surface of the circuit board.

Embodiments of the invention will now be described, with reference to the accompanying drawings, wherein:
Fig. 1 is a perspective view showing an electric connector together with a support member according to a first embodiment of the present invention;
Fig. 2 is an expanded, perspective view showing the support member in Fig. 1;
Fig. 3 is an upper plan view showing the electric connector and support member of Fig. 1 together with a printed circuit board and a support plate;
Fig. 4 is a part-sectional side view corresponding to an arrangement of Fig. 3;
Fig. 5 is a perspective view showing a support member in a second embodiment of the present invention;
Fig. 6 is a perspective view showing, together with a printed circuit board and a support plate, an electric connector and support member according to a third embodiment of the present invention;
Fig. 7 is an upper plan view corresponding to an arrangement of Fig. 6;
Fig. 8 is a side view corresponding to the arrangement of Fig. 7;
Fig. 9 is an expanded, perspective view showing one of the support members in Fig. 6; and
Fig. 10 is an expanded, perspective view showing another support member used in a fourth embodiment of the present invention.

### Detailed Description of the Preferred Embodiments

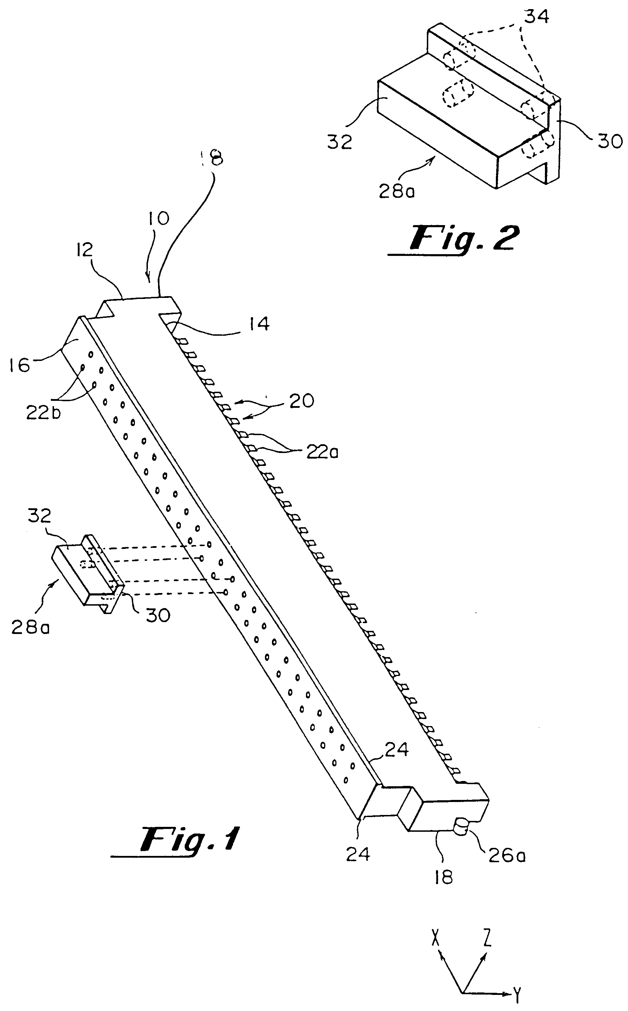

An electric connector, that is, a PCMCIA (Personal Computer Memory Card International Association) receptacle 10, as shown in Fig. 1 has an insulating housing 12 obtained by molding and stretching and possessing conductive pins 20 extending from one of opposed surfaces 14 and 16 of the housing 12 to the other surface. The conductive pins 20 are arranged, as a 2 × 34 array, along the stretching direction (X-axis direction) of the housing 12. Each respective conductive pin 20 has a solder tail 22a at its one end projecting from the surface 14 and a receptive header portion 22b at its other end on the surface 16 of the housing 12. It is preferred that a pair of ribs 24 be provided, in an X-direction, at opposite longitudinal edges of the surface 16 of the housing 12. A positioning peg 26a is provided one at each opposed end face 18 of the housing 12 as viewed in the X-axis direction.

As shown in Fig. 2 in particular, a member or support pad 28a is substantially T-like in cross-section and has a support section 30 to be contacted with the surface 16 of the housing 16 and a grip section 32. The support section 30 has a group of pins 34 to be fitted into a group of the corresponding pin header socket portions 22b. The configuration of the grip section 32 is properly so designed that the grip section 32 can be readily located as will be set out below and readily gripped by a human hand.

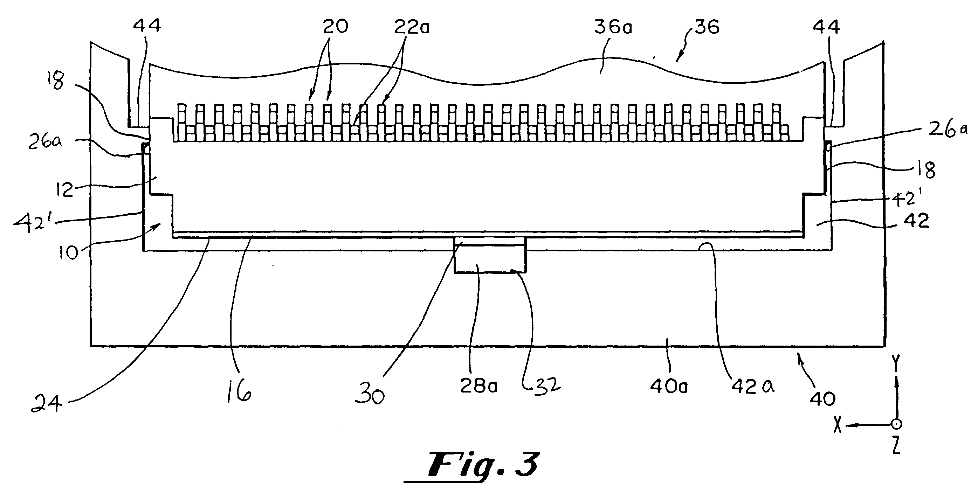

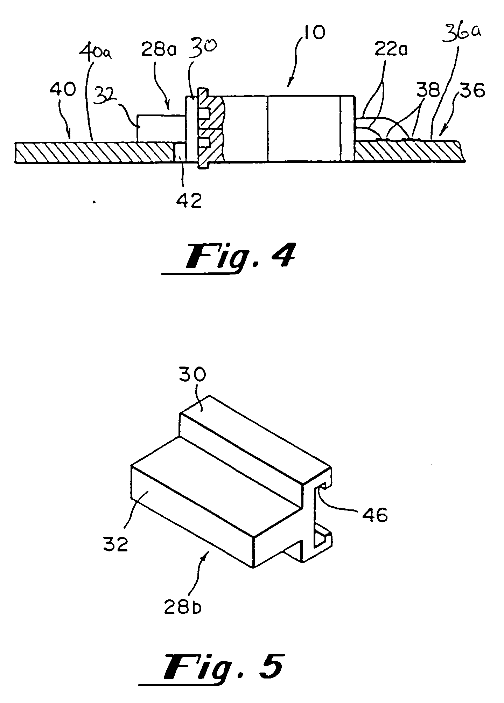

As shown in Figs. 3 and 4, the PCMCIA receptacle 10 is placed in relation to one surface 36a of the printed circuit board 36 from a substantially normal direction (Z-axis direction). In this state, each respective solder tail 22a is seated on a corresponding solder pad 38 on the upper surface 36a of the printed circuit board 36 as shown in Fig. 4.

The PCMCIA receptacle 10 and the printed circuit board 36 have substantially the same dimension as viewed in the X-axis direction.

Before or immediately after the receptacle 10 is placed relative to the surface 36a of the printed circuit board 36, at least one support pad 28a is mounted on a surface 16 of the housing 12 by fitting the pins 34 into the mating header 22b.

A support plate 40 for aiding the placement of the PCMCIA receptacle 10 has an opening or cutout 42 corresponding to the housing 12.

One edge 42a of the opening 42 facing the surface 16 of the housing 12 is spaced apart from the surface 16 of the housing. The edge 42a adjoins edges 42' extending in the X-axis direction which adjoin a pair of projections 44 on the plate 40. The projections 44 are mounted relative to the corresponding positioning pegs 26a of the housing 12. One surface 40a of the support plate 40 lie substantially flush with the surface 36a of the printed circuit board 36. The support plate 40 is made of the same material as that of the printed circuit board 36. The support plate 40 is connected by the pair of projections 44 to the printed circuit board 36. The support plate 40 can be removed, by a breakage or shearing of the projections 44.

The support pad 28a mounted on the surface 16 of the housing is placed on the surface 40 of the support plate 40 on the edge 42a side of the opening 42. The housing 12 is supported, by the projections 44 of the support plate 40, at both the ends of the housing through the positioning pegs 26a and, by the surface 40a of the support plate 40, at the surface 16 of the housing 12 through the support pad 28a. The receptacle 10 is thus located and held in a horizontal attitude relative to the surface 36a of the printed circuit board 36. In this state, the solder tails 22a of the receptacle 10 are soldered to the solder pads 38 of the printed circuit board 36 by a radiation beam or a vapor-phase reflow soldering processing so that the receptacle 10 is held at a horizontal attitude after such a soldering processing has been achieved.

After the soldering processing step, the support plate 40 is removed from the receptacle 10 by breaking or shearing the projections 44. Further, the support pad 28a is removed from the receptacle 10.

After the soldering processing step it is desired that the printed circuit board 36 be washed and this operation can be performed before or after the removable of the support pad 28a and support plate 40.

Fig. 5 shows a support pad 28b in a second embodiment of the present invention. The support pad 28b is different from the support pad 28a in the previous embodiment in that a support section 30 has a pair of grooves 46 for fitting over the corresponding pair of ribs 24 (see Fig. 1) provided on a surface 16 of a housing 12. The ribs 24 of the housing 12 are necessary when the support pad 28b is employed.

The support pad 28b can be detachably fitted over the pair of ribs 24 from each longitudinal end of the housing 12. Further, the support pad 28b can be selectively positioned on the surface 16 of the housing by being slidably moved along the ribs. The second embodiment retains the advantages of the first embodiment but also has other advantages in that it is easier to change the mount position of the support pad 28b relative to the surface 16 of the housing.

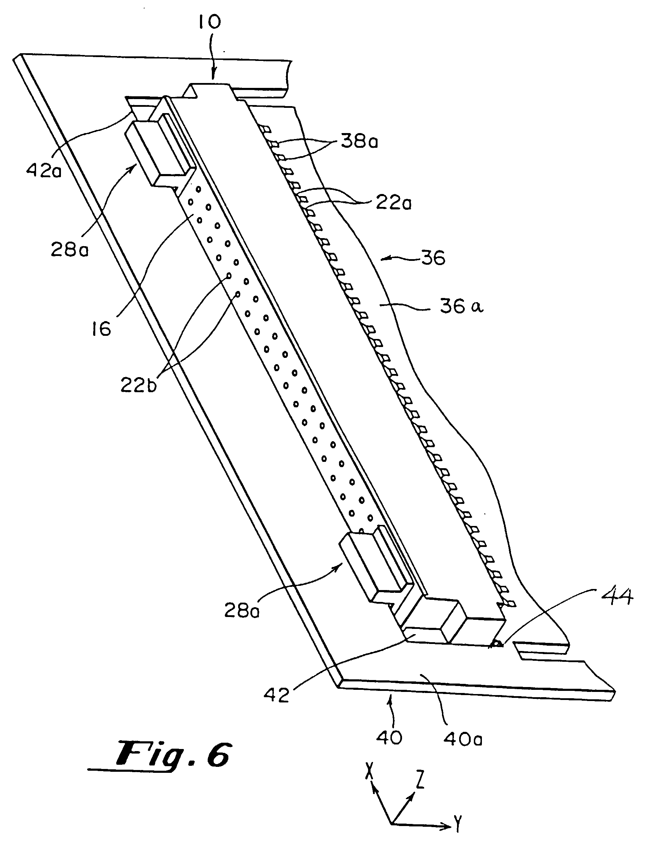

Figs. 6 to 9 show a third embodiment of the present invention. The third embodiment is different from the first embodiment in that support pads 28c and a support plate 40' are used in place of the support pad 28a and support plate 40 and the housing 12 has no positioning pegs 26a.

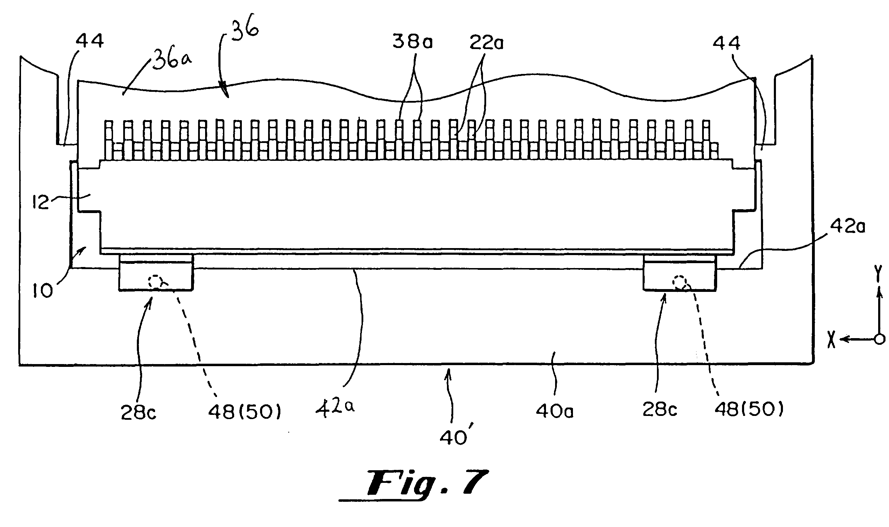

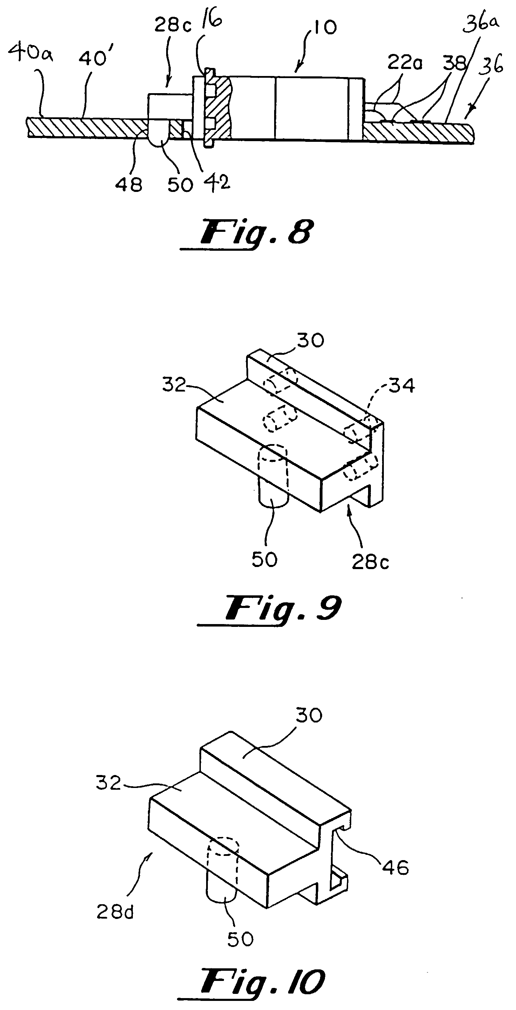

The support plate 40' has a pair of holes 48 (Fig. 7) in the neighborhood of its corresponding edge 42a, and the support pads 28c each have a positioning pin 50 to be detachably fitted into a corresponding hole 48. Except for these features, the support pads 28c and the support plate 40' in the embodiment shown in Figs. 6 and 9 are the same as the support pad 28a and support plate 40 in the first embodiment of the present invention. According to the third embodiment of the present invention, the same advantages as those of the first embodiment can be obtained by positioning the housing 12 with the use of a pair of support pads 28c with positioning pins 50 in place of the positioning pegs 26a.

Fig. 10 shows a support pad 28d in a fourth embodiment of the present invention. The support pad 28d is the same as the support pad 28b shown in Fig. 5 except that the support pad 28d has a positioning pin 50 to be detachably fitted into a corresponding hole 48 (see Fig. 7) of the support plate 40'. According to the fourth embodiment, it is possible to achieve the same advantages as those of the third embodiment of the present invention.

According to the present invention, an electric connector can be reliable held in a horizontal attitude during the soldering step.

According to the the present invention, the electric connector can be supported by a simple structure and hence it is easier to position and hold the electric connector during the soldering step.

## Claims

1. A method of mounting an electric connector (10) on a circuit board (36) with solder pads (38) formed on a surface (36a) thereof, the electric connector comprising an elongated housing (12) having opposite first and second elongated surfaces (14, 16) and a third elongated surface extending between the first and second elongated surfaces (14, 16) in a perpendicular relationship therewith and a plurality of conductive pins (20) extending through the first and second elongated surfaces with solder tails (22a) extending from the first surface (14) of the housing for placement on the solder pads (38), the method comprising the steps of:
providing a support plate (40, 40') breakably connected with the circuit board (36), the support plate including one edge (42a) for confronting the second surface (16) of the housing and having a surface (40a) aligned on substantially the same plane as the surface of the circuit board (36);
providing at least one support member (28a, 28b, 28c) for locating with the surface (40a) of the support plate (40) and the second surface (16) of the housing (12);
placing the housing (12) at a substantially horizontal attitude relative to the surface of the circuit board so that the solder tails of the electric connector are seated on the corresponding solder pads on the electric board;
supporting the housing (12) at the horizontal attitude by means of the support member (28a, 28b, 28c) located on the support plate (40, 40') adjacent the one edge (42a) so as to hold the housing (12) at the horizontal attitude to ensure the positional relationship between the solder tail and the corresponding solder pads and
soldering the solder tails of the electric connector to the corresponding solder pads on the circuit board.

2. A method according to Claim 1 and further comprising breaking the support plate (40, 40') to separate the support plate from the circuit board (36) and removing the support member (28a, 28b, 28c).

3. A method according to Claim 2, wherein the support plate (40, 40') has an opening (42) defining the one edge (42a) aswell as further edges extending from the one edge to projections (44) joined to the circuit board (36) and the support plate (40) is removed and separated from the circuit board (36) by breaking the projections (44).

4. A method according to Claim 3, wherein the housing (12) is provided with pegs (26a) which engage with the projections (44) during the placement and support of the housing (12).

5. A method according to Claim 1, 2, 3 or 4, wherein the support member (28a, 28b, 28c) is of T-shaped configuration with a support section (30) for contacting the second surface (16) of the housing (12) and a seating section (32) for locating on the surface (40a) of the support plate (40).

6. A method according to Claim 5, wherein the support section (30) has pins (34) which are fitted in header socket portions (22b) of some of the conductive pins (20) on the second surface (16) of the housing.

7. A method according to Claim 5, wherein the second surface (16) of the housing (12) has ribs (24) on opposed longitudinal edges and the or each support member (28b) has grooves (46) which fit over the ribs (24) and the support member (28b) is fitted onto the second surface (16) by sliding from one end.

8. A method according to Claim 5, 6 or 7, wherein the support member (28c) has a pin (50) which engages in a hole (48) in the support plate (40') adjacent the one edge (42a).

9. A method according to Claim 8, wherein several support members (28c) are used and the pin (50) in each member (28c) is located in the associated hole (48) in the support plate (40').

10. A connector mounting kit for use in the method according to any one of Claims 1 to 9; the kit comprising a circuit board (36) with solder pads (38) on a surface (36a) thereof, a support plate (40) breakably connected to the circuit board (36) and defining an edge (42a) for confronting an elongate surface (16) of a housing (12) of an electrical connector (10) having conductive pins (20) extending between the elongate surface and a second elongate surface from which the pins (20) extend as solder tails (22a) for soldering onto the solder pads (38) and at least one support member (28a, 28b, 28c) which is adapted to locate and support the housing (12) in relation to a surface (42a) of the support plate (40, 40') aligned with the surface (36a) of the circuit board (36).

11. A kit according to Claim 10, wherein the support plate (40, 40') has an opening (42) defining the one edge (42a) aswell as further edges extending from the one edge to projections (44) joined to the circuit board (36) and the support plate (40) is removably separable from the circuit board (36) by breaking the projections (44).

12. A kit according to Claim 11, wherein the housing (12) is provided with pegs (26a) and the projections (44) serve to engage with the pegs (26a) during the placement and support of the housing (12).

13. A kit according to Claim 10, 11 or 12, wherein the support member (28a, 28b, 28c) is of T-shaped configuration with a support section (30) for contacting the second surface (16) of the housing (12) and a seating section (32) for locating on the surface (40a) of the support plate (40).

14. A kit according to Claim 13, wherein the support section (30) has pins (34) for fitting in header socket portions (22b) of some of the conductive pins (20) on the second surface (16) of the housing.

15. A kit according to Claim 13, wherein the support member (28b) has grooves (46) adapted to fit onto the ribs (24) on opposite longitudinal edges of elongate surface (16) of the housing (12).

16. A kit according to Claim 13, 14 or 15, wherein the support member (28c) has a pin (50) for engaging in a hole (48) in the support plate (40') adjacent the one edge (42a).

## Patentansprüche

1. Verfahren zum Anbringen eines elektrischen Verbinders (10) an einer Leiterplatte (36) mit Lötkissen (38), welche an einer Oberfläche (36a) derselben angebracht sind, wobei der elektrische Verbinder umfaßt ein längliches Gehäuse (12) mit entgegengesetzten ersten und zweiten länglichen Oberflächen (14, 16) und einer dritten länglichen Oberfläche, welche sich zwischen der ersten und der zweiten länglichen Oberfläche (14, 16) in einer orthogonalen Lage zu diesen erstreckt, und eine Mehrzahl von Leiterstiften (20), welche sich durch die erste und die zweite längliche Oberfläche erstrecken, wobei sich Lötschwänze (22a) von der ersten Oberfläche (14) des Gehäuses zum Positionieren auf den Lötkissen (38) erstrecken, wobei das Verfahren die Schritte umfaßt:
Vorsehen einer Halteplatte (40, 40'), welche abbrechbar mit der Leiterplatte (36) verbunden ist, wobei die Halteplatte einen Rand (42a), welcher der zweiten Oberfläche (16) des Gehäuses gegenüberzustellen ist, und eine Oberfläche (40a) aufweist, welche im wesentlichen zu derselben Ebene ausgerichtet ist wie die Oberfläche der Leiterplatte (36);
Vorsehen von wenigstens einem Halteelement (28a, 28b, 28c) zum Positionieren an der Oberfläche (40a) der Halteplatte (40) und der zweiten Oberfläche (16) des Gehäuses (12);
Positionieren des Gehäuses (12) in einer im wesentlichen horizontalen Stellung relativ zu der Oberfläche der Leiterplatte, so daß die Lötschwänze des elektrischen Verbinders auf den entsprechenden Lötkissen auf der elektrischen Leiterplatte aufgesetzt sind;
Halten des Gehäuses (12) in der horizontalen Stellung mittels des Halteelements (28a, 28b, 28c), welches an der Halteplatte (40, 40') benachbart dem einen Rand (42a) angeordnet ist, um das Gehäuse (12) in der horizontalen Stellung zu halten, um die positionelle Beziehung zwischen den Lötschwänzen und den entsprechenden Lötkissen sicherzustellen und
Verlöten der Lötschwänze des elektrischen Verbinders mit den entsprechenden Lötkissen auf der Leiterplatte.

2. Verfahren nach Anspruch 1 und ferner umfassend Abbrechen der Halteplatte (40, 40'), um die Halteplatte von der Leiterplatte (36) zu trennen, und Entfernen des Halteelements (28a, 28b, 28c).

3. Verfahren nach Anspruch 2, wobei die Halteplatte (40, 40') eine Öffnung (42) aufweist, welche den einen Rand (42a) sowie weitere Ränder definiert, welche sich von dem einen Rand zu Vorsprüngen (44) erstrecken, die mit der Leiterplatte (36) verbunden sind, und wobei die Halteplatte (40) von der Leiterplatte (36) durch Abbrechen der Vorsprünge (44) entfernt und getrennt wird.

4. Verfahren nach Anspruch 3, wobei das Gehäuse (12) mit Zapfen (26a) versehen ist, welche mit den Vorsprüngen (44) während der Positionierung und des Haltens des Gehäuses (12) in Eingriff stehen.

5. Verfahren nach Anspruch 1, 2, 3 oder 4, wobei das Halteelement (28a, 28b, 28c) einen T-förmigen Aufbau mit einem Halteabschnitt (30) zum Kontaktieren der zweiten Oberfläche (16) des Gehäuses (12) und einem Sitzabschnitt (32) zum Positionieren auf der Oberfläche (40a) der Halteplatte (40) aufweist.

6. Verfahren nach Anspruch 5, wobei der Halteabschnitt (30) Stifte (34) aufweist, welche in Kopf-Sockel-Abschnitte (22b) von einigen der Leiterstifte (20) an der zweiten Oberfläche (16) des Gehäuses eingesetzt werden.

7. Verfahren nach Anspruch 5, wobei die zweite Oberfläche (16) des Gehäuses (12) Rippen (24) an entgegengesetzten Längsrändern aufweist und wobei das oder jedes Halteelement (28b) Vertiefungen (46) aufweist bzw. aufweisen, welche über die Rippen (24) passen, und wobei das Halteelement (28b) auf die zweite Oberfläche (16) durch Aufschieben von einem Ende her aufgesetzt wird.

8. Verfahren nach Anspruch 5, 6 oder 7, wobei das Halteelement (28c) einen Stift (50) aufweist, weicher in ein Loch (48) in der Halteplatte (40') benachbart dem einen Rand (42a) eingreift.

9. Verfahren nach Anspruch 8, wobei mehrere Halteelemente (28c) verwendet werden und wobei der Stift (50) in jedem Element (28c) in dem zugeordneten Loch (48) der Halteplatte (40') positioniert ist.

10. Verbinderanbring-Set zur Verwendung bei dem Verfahren nach einem der Ansprüche 1 bis 9, wobei das Set umfaßt: eine Leiterplatte (36) mit Lötkissen (38) an einer ihrer Oberflächen (36a), eine Halteplatte (40), welche abbrechbar mit der Leiterplatte (36) verbunden ist und einen Rand (42a) definiert, welcher einer länglichen Oberfläche (16) eines Gehäuses (12) eines elektrischen Verbinders (10) mit Leiterstiften (20) gegenüberzustellen ist, welche Leiterstifte sich zwischen der länglichen Oberfläche und einer zweiten länglichen Oberfläche erstrecken, von welcher die Stifte (20) sich als Lötschwänze (22a) zum Verlöten auf Lötkissen (38) erstrecken, und wenigstens ein Halteelement (28a, 28b, 28c), welches dazu ausgelegt ist, das Gehäuse (12) relativ zu einer Oberfläche (42a) der Halteplatte (40, 40') zu positionieren und zu halten, welche zu der Oberfläche (36a) der Leiterplatte (36) ausgerichtet ist.

11. Set nach Anspruch 10, wobei die Halteplatte (40, 40') eine Öffnung (42) aufweist, welche den einen Rand (42a) sowie weitere Ränder definiert, welche sich von dem einen Rand zu Vorsprüngen (44) erstrecken, die mit der Leiterplatte (36) verbunden sind, und wobei die Halteplatte (40) durch Abbrechen der Vorsprünge (44) von der Leiterplatte (36) entfernbar abtrennbar ist.

12. Set nach Anspruch 11, wobei das Gehäuse (12) mit Zapfen (26a) versehen ist und wobei die Vorsprünge (44) dazu dienen, mit den Zapfen (26a) während der Positionierung und während des Haltens des Gehäuses (12) in Eingriff zu stehen.

13. Set nach Anspruch 10, 11 oder 12, wobei das Halteelement (28a, 28b, 28c) einen T-förmigen Aufbau mit einem Halteabschnitt (30) zum Kontaktieren der zweiten Oberfläche (16) des Gehäuses (12) und einem Sitzabschnitt (32) zum Positionieren auf der Oberfläche (40a) der Halteplatte (40) aufweist.

14. Set nach Anspruch 13, wobei der Halteabschnitt (30) Stifte (34) zum Einsetzen in Kopf-Sockel-Bereiche (22b) von einigen der Leiterstifte (20) an der zweiten Oberfläche (16) des Gehäuses aufweist.

15. Set nach Anspruch 13, wobei das Halteelement (28b) Vertiefungen (46) aufweist, welche derart ausgelegt sind, dass sie auf die Rippen (24) an entgegengesetzten Längsrändern der länglichen Oberfläche (16) des Gehäuses (12) passen.

16. Set nach Anspruch 13, 14 oder 15, wobei das Halteelement (28c) einen Stift (50) zum Eingreifen in ein Loch (48) in der Halteplatte (40') benachbart dem einen Rand (42a) aufweist.

## Revendications

1. Procédé de montage d'un connecteur électrique (10) sur une plaquette de circuits (36) comportant des plots de soudure (38) formés sur l'une de ses surfaces (36a), le connecteur électrique comprenant un boîtier de forme allongée (12) ayant des première et seconde surfaces opposées et de forme allongée (14, 16) et une troisième surface de forme allongée s'étendant entre les première et seconde surfaces de forme allongée (14, 16) perpendiculairement à elle et une pluralité de broches conductrices (20) s'étendant à travers les première et seconde surfaces de forme allongée, présentant des casses-à- souder (22a) s'étendant à partir de la première surface (14) du boîtier pour se placer sur les plots de soudure (38), le procédé comprenant les étapes consistant à :
fournir une plaque de support (40,40') connectée de façon séparable par rupture avec la plaquette de circuits (36), la plaque de support incluant une première bordure (42a) pour faire face à la seconde surface (16) du boîtier et présentant une surface (40a) alignée essentiellement sur le même plan que la surface de la plaquette de circuits (36),
fournir au moins un élément de support (28a, 28b, 28c) pour positionner la surface (40a) de la plaque de support (40) et la seconde surface (16) du boîtier (12),
placer le boîtier (12) en position essentiellement horizontale par rapport à la surface de la plaquette de circuits de façon que les casses-à-souder du connecteur électrique reposent sur les plots de soudure correspondants de la plaquette électrique,
supporter le boîtier (12) à la position horizontale au moyen de l'élément de support (28a, 28b, 28c) placé sur la plaque de support (40, 40') de façon adjacente à la première bordure (42a) de façon à maintenir le boîtier (12) en position horizontale pour assurer le placement relatif entre la casse-à-souder et les plots de soudure correspondants et
souder les casses-à-souder du connecteur électrique sur les plots de soudure correspondants de la plaquette de circuits.

2. Procédé selon la revendication 1 et consistant, de plus, à dégager par rupture la plaque de support (40, 40') pour séparer la plaque de support de la plaquette de circuits (36) et à retirer l'élément de support (28a, 28b, 28c).

3. Procédé selon la revendication 2, dans lequel la plaque de support (40, 40') comporte une ouverture (42) définissant la première bordure (42a) de même que d'autres bordures s'étendant de la première bordure vers des parties en saillie (44) raccordées à la plaquette de circuits (36) et la plaque de support (40) est retirée et séparée de la plaquette de circuits (36) en rompant les parties en saillie (44).

4. Procédé selon la revendication 3, dans lequel le boîtier (12) est doté de goupilles (26a) qui coopèrent avec les parties en saillie (44) pendant la mise ne place et le soutien du boîtier (12).

5. Procédé selon la revendication 1, 2, 3 ou 4 dans lequel l'élément de support (28a, 28b, 28c) présente une configuration en T, avec une section de support (30) pour être en contact avec la seconde surface (16) du boîtier (12) et une section d'appui (32) pour se placer sur la surface (40a) de la plaque de support (40).

6. Procédé selon la revendication 5, dans lequel la section de support (30) comporte des broches (34) qui sont ajustées dans les parties femelles de branchement de (22b) de certaines des broches conductrices (20) situées sur la seconde surface (16) du boîtier.

7. Procédé selon la revendication 5, dans lequel la seconde surface (16) du boîtier (12) comporte des nervures (24) sur les bordures opposées longitudinales et le ou chaque élément de support (28b) comporte des gorges (46) qui s'ajustent sur les nervures (24) et l'élément de support 28b est ajusté sur la seconde surface (16) par coulissage à partir d'une extrémité.

8. Procédé selon la revendication 5, 6 ou 7, dans lequel l'élément de support (28c) comporte une broche (50) qui s'engage dans un trou (48) de la plaque de support (40') adjacent à la première bordure (42a).

9. Procédé selon la revendication 8, dans lequel plusieurs éléments de support (28c) sont utilisés et la broche (50) dans chaque élément (28c) est placée dans le trou associé (48) de la plaque de support (40').

10. Ensemble de fixation de connecteur à utiliser dans le procédé selon l'une quelconque des revendications 1 à 9, l'ensemble comprenant une plaquette de circuits (36) comportant des plots de soudure (38) sur l'une de ses surfaces (36a), une plaque de support (40) connectée de façon séparable par rupture à la plaquette de circuits (36) et définissant une bordure (42a) pour faire face à une surface de forme allongée (16) d'un boîtier (12) de connecteur électrique (10) comportant des broches conductrices (20) s'étendant entre la surface de forme allongée et une seconde surface de forme allongée à partir de laquelle les broches (20) s'étendent sous forme de casses-à-souder (22a) pour être soudées sur les plots de soudure (38) et au moins un élément de support (28a, 28b, 28c) qui est adapté pour placer et soutenir le boîtier (12) par rapport à une surface (42a) de la plaque de support (40, 40') alignée avec la surface (36a) de la plaquette de circuits (36).

11. Ensemble selon la revendication 10, dans lequel la plaque de support (40, 40') comporte une ouverture (42) définissant la première bordure (42a) de même que d'autres bordures s'étendant de la première bordure vers des parties en saillie (44) raccordées à la plaquette de circuit (36) et la plaque de support (40) peut être séparée par retrait de la plaquette de circuits (36) en rompant les parties en saillie (44).

12. Ensemble selon la revendication 11, dans lequel le boîtier (12) est doté de goupilles (26a) et les parties en saillie (44) servent à coopérer avec les goupilles (26a) pendant la mise en place et le support du boîtier (12).

13. Ensemble selon la revendication 10, 11 ou 12, dans lequel l'élément de support (28a, 28b, 28c) présente une configuration en T avec une section de support (30) pour entrer en contact avec la seconde surface (16) du boîtier (12) et une section d'appui (32) pour se placer sur la surface (40a) de la plaque de support (40).

14. Ensemble selon la revendication 13, dans lequel la section de support (30) comporte des broches (34) pour s'ajuster dans des parties femelles de branchement (22b) de certaines des broches conductrices (20) sur la seconde surface (16) du boîtier.

15. Ensemble selon la revendication 13, dans lequel l'élément de support (28b) comporte des gorges (46) adaptées pour s'ajuster sur les nervures (24) situées sur les bordures opposées longitudinales de la surface de forme allongée (16) du boîtier (12).

16. Ensemble selon la revendication 13, 14, ou 15 dans lequel l'élément de support (28c) comporte une broche (50) pour s'engager dans un trou (48) de la plaque de support (40') adjacent à la bordure (42a).
